**Europäisches Patentamt**

**European Patent Office**

**Office européen des brevets**

(19)

(11) **EP 1 104 053 A2**

(12) **EUROPEAN PATENT APPLICATION**

(43) Date of publication:
**30.05.2001 Bulletin 2001/22**

(51) Int Cl.⁷: **H01S 5/024**

(21) Application number: **00125911.8**

(22) Date of filing: **27.11.2000**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI** | (71) Applicant: **NEC CORPORATION**<br>**Tokyo (JP)** |
| (30) Priority: **29.11.1999 JP 33749199** | (72) Inventor: **Kosugi, Tomonari, NEC Corporation**<br>**Tokyo (JP)**<br><br>(74) Representative: **VOSSIUS & PARTNER**<br>**Siebertstrasse 4**<br>**81675 München (DE)** |

(54) **Semiconductor laser module**

(57)     There is provided a semiconductor laser module including (a) a semiconductor laser (208). (b) a cooler (205) which cools the semiconductor laser (208), (c) a package bottom (102) on which the cooler (205) is mounted, (d) a package housing (203, 203A, 203B) mounted on the package bottom (102), the package housing (203, 203A, 203B) cooperating with the package bottom (102) to define a package in which the semiconductor laser (208) and the cooler (205) are arranged, and (e) a ground terminal (106G) outwardly extending from the package housing (203) and electrically connected to a ground terminal of the semiconductor laser (208), characterized by the heat insulator (202) sandwiched between the package bottom (102) and the package housing (203) for preventing heat from being transferred between the package bottom (102) and the package housing (203).

# FIG. 3

## Description

The invention relates to a semiconductor laser module, and more particularly to a semiconductor laser module including a module package in which a laser cooler is mounted.

A semiconductor laser module is a signal source including a semiconductor laser therein, and is used in various optic devices such as an optical fiber transfer device. Many suggestions have been made to reduce power consumption in electronic devices such as a computer, and also in a semiconductor laser module.

For instance, a semiconductor laser module incorporated in a circuit board in a transfer device is required to reduce its power consumption. as power consumption in the circuit board has been reduced. In order to reduce power consumption in a semiconductor laser module, it is a key to enhance an efficiency of a cooler for cooling a semiconductor laser.

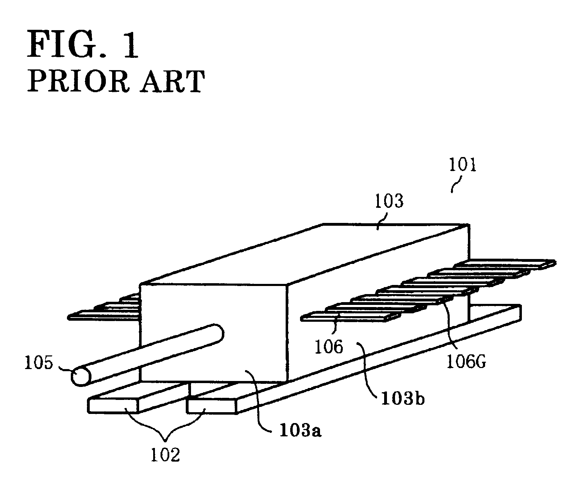

Fig. 1 is a perspective view of a conventional semiconductor laser module.

The illustrated semiconductor laser module 101 includes a package bottom 102 and a package housing 103 mounted on the package bottom 102. The package bottom 102 is composed of CuW, and the package housing 103 is composed of Fe-Ni-Co. The package housing 103 is hollow, and a semiconductor laser, an optic lens and an electronic cooler (all not illustrated) are arranged in the package housing 103.

An optical fiber 105 is fixed at its end to a sidewall 103a of the package housing 103 by YAG (yttrium aluminum garnet) welding. The optical fiber 105 transfers a laser beam therethrough which is transmitted from a semiconductor laser arranged in the package housing 103.

A plurality of terminals 106 is fixed to and outwardly extend from sidewalls 103b of the package housing 103. One of the terminals 106 is a ground terminal 106G.

The semiconductor laser module 103 is accompanied with a problem as follows.

In the semiconductor laser module 101, heat emitted from the electronic cooler arranged in the package housing 103 is transferred from the package bottom 102 to the package housing 103. The ground terminal 106G is connected not only to the sidewall 103b of the package housing 103, but also to a substrate on which a semiconductor laser is mounted, through a bonding wire (not illustrated). As a result, heat having been transferred to the package housing 103 from the package bottom 102 is first transferred to the ground terminal 106G, and then, to the substrate through the bonding wire.

Thus, in the conventional semiconductor laser module, a part of heat emitted from a semiconductor laser returns back to the semiconductor laser, resulting in that a cooling efficiency of the semiconductor laser module is deteriorated in accordance with the returned heat, and accordingly, power consumption is increased.

Many attempts have been made to reduce heat returning back to a semiconductor laser from the package housing 103. For instance. Japanese Unexamined Utility Model Publication No. 5-8511 has suggested a semiconductor laser module to reduce such heat.

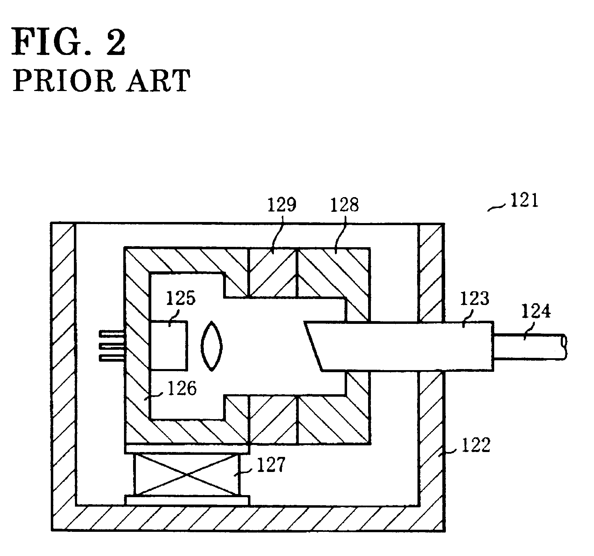

Fig. 2 illustrates the semiconductor laser module suggested in the Publication.

In the illustrated semiconductor laser module 121, an optical fiber 124 is inserted at its one end into a ferrule 123 fixed to and across a package housing 122. A semiconductor laser 125 is supported by a laser holder 126, and is connected to an electronic cooler 127 through the laser holder 126. A heat insulator 129 is sandwiched between the laser holder 126 and an optical fiber holder 128 to which the ferrule 123 is fixed.

In the semiconductor laser module 121, heat generated in the semiconductor laser 125 is absorbed in the electronic cooler 127, and then, transferred to the package housing 122. The heat is transferred further to the optical fiber holder 128 through the ferrule 123, but is not transferred to the laser holder 126, because the heat insulator 129 prevents the heat from being transferred to the laser holder 126.

For another instance, Japanese Unexamined Patent Publication No. 1-122183 has suggested a semiconductor laser module including a first inner container in which a semiconductor laser is arranged, and a second outer container in which the first inner container is arranged. The first and second containers are spaced away from each other to define a sufficiently large space therebetween, and an electronic cooler is located in the space. Thus, heat having been transferred from the electronic cooler to the second container is unlikely to be transferred to the first container in which a semiconductor laser is arranged.

However, in the semiconductor laser modules illustrated in Fig. 2 and suggested in Japanese Unexamined Patent Publication No. 1-122183, though a semiconductor lager is physically insulated, no attempt is made to prevent heat from being transferred through a ground terminal, as having been explained with reference to Fig. 1.

For instance. in the semiconductor laser module 121 illustrated in Fig. 2, a ground terminal (not illustrated) fixed to the package housing 122 is connected to the semiconductor laser 125 at its ground side through a bonding wire. Accordingly, heat having been transferred to the package housing 122 is transferred further to the semiconductor laser 125 through the bonding wire. Thus, the problem of deterioration in a cooling efficiency and resultingly an increase in power consumption remains unsolved.

Japanese Unexamined Patent Publication No. 3-238408 has suggested an optic semiconductor laser module including an electronic cooler fixed inside a case, a first optical system comprising a semiconductor laser and a micro-lens, fixed onto the electronic cooler, and a second optical system comprising an optical fiber and a micro-lens, fixed to a sidewall of the case. The second optical system is fixedly welded onto an optical L-shaped solid base, and the first optical system is fixedly welded onto the base by means of support pillars having a great thermal resistance and standing at opposite sides of the electronic cooler.

Japanese Unexamined Patent Publication No. 4-355706 has suggested a semiconductor laser module including a semiconductor laser, an optical fiber, and a lens through which the semiconductor laser and the optical fiber is coupled. An electronic cooler is sandwiched between a lower surface of a first insulating plate and an upper surface of a second insulating plate. The second insulating plate is fixed at its lower surface onto a bottom of a package. A header supporting the semiconductor laser therewith and a lens holder holding the lens are both fixed to a pattern formed on an upper surface of the first insulating plate.

However, the above-mentioned problem of deterioration in a cooling efficiency and resultingly an increase in power consumption remains unsolved even in those semiconductor laser modules.

In view of the above-mentioned problem in the conventional semiconductor laser module, it is an object of the present invention to provide a semiconductor laser module which is capable of preventing heat generated in a semiconductor laser, from returning back thereto through a ground terminal or a bonding wire.

There is provided a semiconductor laser module including (a) a semiconductor laser, (b) a cooler which cools the semiconductor laser, (c) a package bottom on which the cooler is mounted, (d) a package housing mounted on the package bottom, the package housing cooperating with the package bottom to define a package in which the semiconductor laser and the cooler are arranged, and (e) a ground terminal electrically connected to a ground terminal of the semiconductor laser, characterized by (f) a heat insulator which prevents heat generated in the semiconductor laser, from returning back to the semiconductor laser through the ground terminal.

For instance, the heat insulator may be sandwiched between the package bottom and the package housing for preventing heat from being transferred between the package bottom and the package housing, in which case, the ground terminal may outwardly extend from the package housing or the ground terminal may outwardly extends from the heat insulator.

In the semiconductor laser module, the heat insulator prevents heat having been transferred to the package bottom from being transferred to the package housing. Hence, it is possible to prevent heat emitted from the semiconductor laser, from returning back to the semiconductor laser through the ground terminal.

For instance, the heat insulator is composed of ceramics.

It is preferable that the ground terminal is electrically connected to the package housing.

By electrically connecting the ground terminal to the package housing, electric noises can be interrupted.

It is preferable that the heat insulator has the same cross-section as that of the package housing.

It is preferable that the semiconductor laser module further includes a substrate on which the semiconductor laser is mounted and which is grounded, and wherein the ground terminal is electrically connected to the substrate, and that the ground terminal outwardly extends from the package housing.

In the semiconductor laser module. the heat insulator prevents heat having been transferred to the package bottom from being transferred to the package housing. Hence, it is possible to prevent heat emitted from the semiconductor laser, from returning back to the semiconductor laser through the ground terminal.

It is preferable that the package housing is composed of heat insulating material such that the package housing acts also as the heat insulator.

In the semiconductor laser module, the package housing is composed of heat insulating material. Hence. it is possible to prevent heat having been transferred to the package bottom, from being transferred to the package housing.

In addition, when terminals fixed onto the package housing, it would not be necessary to electrically insulate the terminals to each other, because heat-insulating material of which the package housing is composed has a high electric resistance.

## BRIEF DESCRIPTION OF THE DRAWINGS

Fig. 1 is a perspective view of a conventional semiconductor laser module.

Fig. 2 is a cross-sectional view of another conventional semiconductor laser module.

Fig. 3 is a perspective view of a semiconductor laser module in accordance with the first embodiment.

Fig. 4 is a cross-sectional view taken along the line A-A in Fig. 3.

Fig. 5 is a cross-sectional view taken along the line B-B in Fig. 3.

Fig. 6 is a perspective view of a semiconductor laser module in accordance with the second embodiment.

Fig. 7 is a perspective view of a semiconductor laser module in accordance with the third embodiment.

## DESCRIPTION OF THE PREFERRED EMBODIMENTS

Preferred embodiments in accordance with the present invention will be explained hereinbelow with reference to drawings.

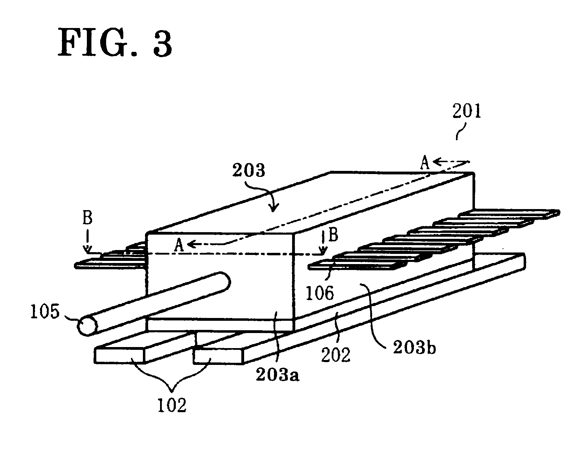

Fig. 3 is a perspective view of a semiconductor laser module 201 in accordance with the first embodiment.

As illustrated in Fig. 3. the semiconductor module 201 includes a package bottom 102, a package housing 203 mounted above the package bottom 102, a heat insulator 202 sandwiched between the package bottom 102 and the package housing 203, an optical fiber 105, and a plurality of terminals 106.

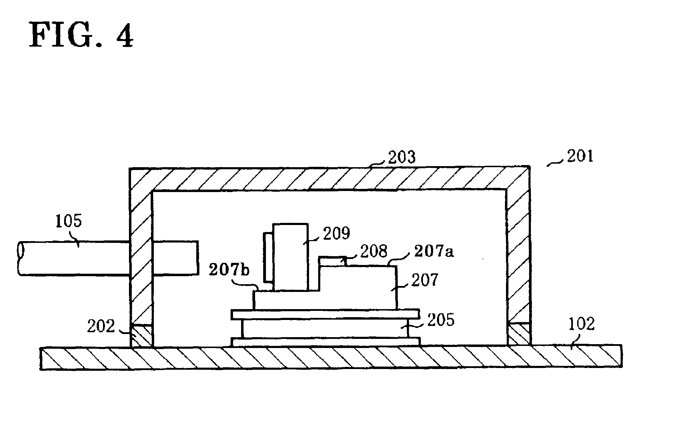

As illustrated in Fig. 4, an electronic cooler 205 is mounted on the package bottom 102 in the package housing 203. A substrate 207 having a step defined by an upper surface 207a and a lower surface 207b is fixedly soldered on the electronic cooler 205. A semiconductor laser 208 is fixed on the upper surface 207a, and a lens 209 is fixed on the lower surface 207b by YAG (yttrium aluminum garnet) welding.

The heat insulator 202 has a cross-section like a window frame, namely, is open inside. The package housing 203 mounted on the heat insulator 202 has the same cross-section as that of the heat insulator 202.

An optical fiber 105 is fixed at its end to a sidewall 203a of the package housing 203 by YAG welding. The optical fiber 105 transfers a laser beam therethrough which is transmitted from the semiconductor laser 208.

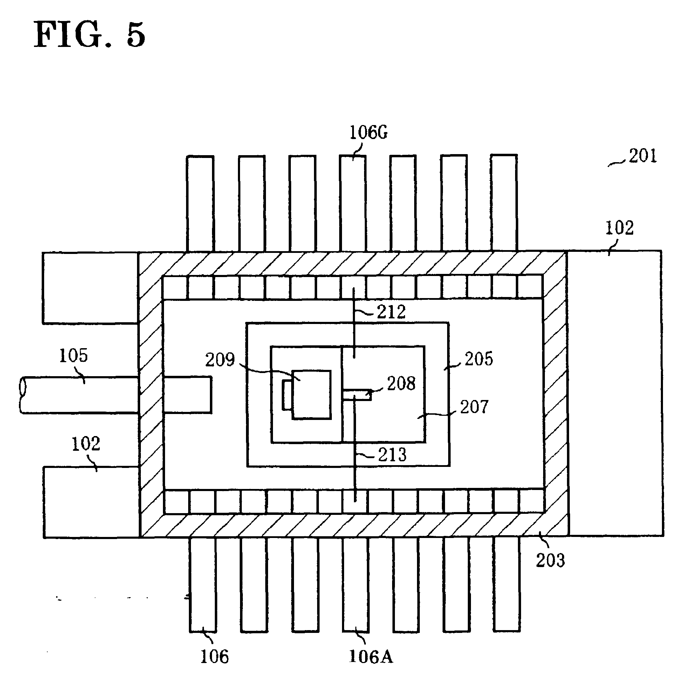

The terminals 106 are fixed to and outwardly extend from sidewalls 203b of the package housing 103. One of the terminals 106 is a ground terminal 106G, as illustrated in Fig. 5.

The package bottom 102 is composed of CuW, and the package housing 203 is composed of Fe-Ni-Co.

The heat insulator 202 is composed of a material having a small coefficient of thermal conductivity such as ceramics. The heat insulator 202 in the first embodiment is composed of forsterite.

Fig. 4 is a cross-sectional view of the semiconductor laser module 201 taken along the line A-A in Fig. 3.

The package housing 203 is fixed on the package bottom 102 with the heat insulator 202 being sandwiched therebetween.

The electronic cooler 205 is fixedly soldered onto the package bottom 102 such that a bottom surface of the electronic cooler 205 makes a surface contact with the package bottom 102.

As mentioned earlier, the semiconductor laser 208 is mounted on the upper surface 207a, and the lens 209 is mounted on the lower surface 207b. A height D of the step is defined as follows.

$$R = D+H$$

In the equation, R indicates a radius of the lens 209, and H indicates a height of the semiconductor laser 208. That is, a height of a laser beam emitted from the semiconductor laser 208 is equal to a height of the semiconductor laser 208.

Laser beams emitted from the semiconductor laser 208 are collected at the lens 209, and optically coupled to the optical fiber 105. As is obvious in view of the foregoing, an axis of laser beams emitted from the semiconductor laser 208 is coincident with both an axis of the lens 209 and an axis of the optical fiber 105.

Fig. 5 is a cross-sectional view taken along the line B-B in Fig. 3.

The electronic cooler 205 is fixed on the package bottom 102, and the semiconductor laser 208 and the lens 209 are located above the electronic cooler 205.

A plurality of the terminals 106 extends through the sidewalls 203b of the package housing 203, and has ends located in the package housing 203. The ground terminal 106G is electrically connected not only to the package housing 203, but also to the substrate 207 through a boding wire 212. The terminals 106 other than the ground terminal 106G are electrically insulated from the package housing 203. A certain terminal 106A among the terminals 106 other than the ground terminal 106G is electrically connected to a driver terminal (not illustrated) of the semiconductor laser 208 through a boding wire 213.

The semiconductor laser 208 is electrically connected at its ground terminal (not illustrated) to the substrate 207.

Though the semiconductor laser module 201 illustrated in Figs. 3 to 5 is designed to have only one ground terminal 106G, the semiconductor laser module 201 may be designed to have two or more ground terminals.

In the semiconductor laser module 201 having such a structure as mentioned above, heat generated in the semiconductor laser 208 is first absorbed into the electronic cooler 205, and then, exhausted to the package bottom 102 from the electronic cooler 205. Thus, the semiconductor laser 208 is kept in a desired range of temperature.

Between the package bottom 102 and the package housing 203 is sandwiched the heat insulator 202. Hence, the heat insulator 202 prevents heat having been exhausted to the package bottom 102, from transferring to the package housing 203. As a result, it is possible to prevent the heat from transferring to the substrate 207 from the ground terminal 106G through the bonding wire 212.

As mentioned above, the first embodiment makes it possible to prevent heat generated in the semiconductor laser 208, from returning back to the semiconductor laser 208, ensuring enhancement of a cooling coefficient and hence reduction in power consumption.

The package bottom 102 is designed longer than the package housing 203 in a length-wise direction in the first embodiment. This is for the purpose of readily carrying out YAG welding and mounting of the package bottom 102 onto a printed board (not illustrated). The package bottom 102 may be designed shorter than or equal in a length to the package housing 203. In addition, the package bottom 102 may be designed to have a shape other than the shape illustrated in Figs. 3 and 5.

Though the heat insulator 202 is located between the package bottom 102 and the package housing 203 in the first embodiment, it should be noted that the heat insulator 202 may be located anywhere if the heat insulator 202 is thermally insulated from the ground terminal 106G. The heat insulator 202 may have a shape and/or a size other than those illustrated in Figs. 3 to 5.

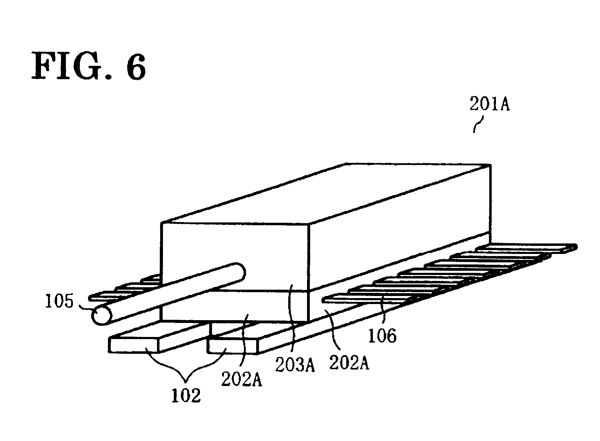

Fig. 6 is a perspective view of a semiconductor laser module 201A in accordance with the second embodiment.

In the second embodiment, a heat insulator 202A is designed to have a greater thickness than a thickness of the heat insulator 202 in the first embodiment, and the terminals 106 including the ground terminal 106G are designed to be fixed to the heat insulator 202A. The semiconductor laser module 201A has the same structure as the structure of the semiconductor laser module 201 other than the above-mentioned heat insulator 202A and the terminals 106.

In accordance with the second embodiment, it is no longer necessary to thermally insulate the terminals 106 from a package housing 203A.

Though not illustrated, only the ground terminal 106G among the terminals 106 is designed to have such a shape that the ground terminal 106G makes contact with the package housing 203A in order to electrically connect the ground terminal 106G to the package housing 203A.

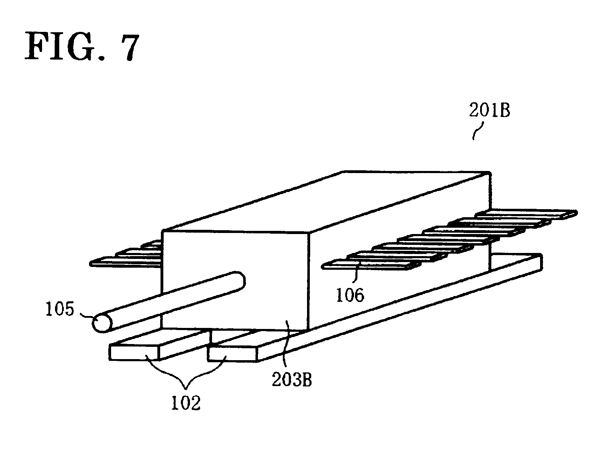

Fig. 7 is a perspective view of a semiconductor laser module 201B in accordance with the third embodiment.

The semiconductor laser module 201B in accordance with the third embodiment is structurally different from the semiconductor laser module 201 in accordance with the first embodiment only in that the semiconductor laser module 201B has no parts corresponding to the heat insulator 202, and that a package housing 203B is composed of heat insulating material such as ceramics.

Though the semiconductor laser module 201B has no parts corresponding to the heat insulator 202 in the first embodiment, since the package housing 203B acts as a heat insulator, it is possible to prevent heat having been transferred to the package bottom 102, from returning back to the semiconductor laser through the ground terminal 106G.

**Claims**

1. A semiconductor laser module comprising:

   (a) a semiconductor laser (208);
   (b) a cooler (205) which cools the semiconductor laser (208);
   (c) a package bottom (102) on which the cooler (205) is mounted;
   (d) a package housing (203, 203A, 203B) mounted on the package bottom (102), the package housing (203, 203A, 203B) cooperating with the package bottom (102) to define a package in which the semiconductor laser (208) and the cooler (205) are arranged; and
   (e) a ground terminal (106G) electrically connected to a ground terminal of the semiconductor laser (208),

   characterized by
   (f) a heat insulator (202, 202A, 203B) which prevents heat generated in the semiconductor laser (208), from returning back to the semiconductor laser (208) through the ground terminal (106G).

2. The semiconductor laser module as set forth in claim 1, wherein the heat insulator (202) is sandwiched between the package bottom (102) and the package housing (203) for preventing heat from being transferred between the package bottom (102) and the package housing (203), and wherein the ground terminal (106G) outwardly extends from the package housing (203).

3. The semiconductor laser module as set forth in claim 1, further comprising a substrate (207) on which the semiconductor laser (208) is mounted and which is grounded, and wherein the ground terminal (106G) is electrically connected to the substrate (207). and wherein the ground terminal (106G) outwardly extends from the package housing (203).

4. The semiconductor laser module as set forth in claim 1, further comprising a substrate (207) on which the semiconductor laser (208) is mounted and which is grounded, and wherein the ground terminal (106G) is electrically connected to the substrate (207), and wherein the ground terminal (106G) outwardly extends from the heat insulator (202A).

5. The semiconductor laser module as set forth in claim 1, wherein the package housing (203B) is composed of heat insulating material such that the package housing (203B) acts also as the heat insulator.

6. The semiconductor laser module as set forth in claim 3, wherein the package housing (203B) is composed of heat insulating material such that the package housing (203B) acts also as the heat insulator.

7. The semiconductor laser module as set forth in claim 1, wherein the heat insulator (202A) is sandwiched between the package bottom (102) and the package housing (203A) for preventing heat from being transferred between the package bottom (102) and the package housing (203A), and wherein the ground terminal (106G) outwardly extends from the heat insulator (202A).

8. The semiconductor laser module as set forth in any one of claims 1 to 7, wherein the heat insulator (202, 202A, 203B) is composed of ceramics.

9. The semiconductor laser module as set forth in any one of claim 1 to 7, wherein the ground terminal (106G) is electrically connected to the package housing (203, 203A).

10. The semiconductor laser module as set forth in any one of claims 1 to 4 and 7, wherein the heat insulator (202, 202A) has the same cross-section as that of the package housing (203, 203A).

# FIG. 1
## PRIOR ART

# FIG. 2
## PRIOR ART

# FIG. 3

# FIG. 4

EP 1 104 053 A2

FIG. 5

11

# FIG. 6

FIG. 7